# EUROPEAN PATENT APPLICATION

(11) **EP 0 632 497 A2**
(43) Date of publication of application: **04.01.1995**
(21) Application number: 94304358.8
(22) Date of filing: 16.06.1994
(51) Int. Cl.: H01L 23/28, H01L 21/48, H01L 23/538

(54) **Multichip module substrate structure**

(30) Priority: 02.07.1993 GB 9313720
(71) Applicant: PLESSEY SEMICONDUCTORS LIMITED, Swindon, Wiltshire SN2 2QW (GB)
(72) Inventor: Pedder, David John, Long Compton, Warwickshire (GB)
(74) Representative: Hoste, Colin Francis

(57) **Abstract**

A multichip module structure incorporating a multilayer metallisation polymer dielectric deposition on a substrate wherein below the uppermost metallisation layer there is deposited a silicon nitride layer. Preferably a silicon nitride layer is also deposited above the uppermost metallisation layer.

## Description

The multichip module (MCM) approach to interconnection and packaging employs unpackaged, naked die mounted onto a high interconnection density substrate structure, with the resulting assembly then packaged to form a module. This removal of the individual die packaging overhead allows very close die proximity (from 0.4 to 2mm die spacings typical) and a high functional density to be achieved. This technology also provides a considerable area and weight saving over the equivalent circuit function realised using individually packaged ICs and surface mount assembly. Typical area savings of between 5 and 10 fold at the substrate level may be achieved. The area fraction of functional silicon in this technology when measured at the substrate level is a function of the assembly method employed. For wire bonded modules this area fraction is typically 30 to 60 per cent, while flip chip solder bonded module assemblies can provide area fractions of up to 80 per cent. Improvements in reliability are also achieved through the elimination of package leads, solder joints and other materials interfaces in the transition from individual to multichip packaging. Performance improvements are achieved through the elimination of individual device package parasitics and the typically three fold reduction in inter-device trace lengths.

A number of categories of MCM technology have now been defined, describing the type of substrate structure employed to interconnect the naked die in the MCM assembly. The MCM-L category uses very fine line, multilayer printed circuit board (pcb) substrate structures that are fabricated using extensions of existing pcb manufacturing techniques. Such substrates are suited for interconnect only, all digital modules with low or medium power dissipation and medium wiring density demand (i.e. medium device pin count). They offer the lowest cost per unit area of the MCM substrate alternatives and employ typically up to 6 metal and dielectric layers. The MCM-C category uses cofired, multilayer ceramic technologies to provide the required interconnection structure. Since the track geometries in this technology are commonly defined by screen printing, which implies limited resolution, the required routing density is achieved by employing additional layers in the multilayer substrate structure. MCM-C modules with up to 40 layers have been reported. The MCM-C substrate structure may be readily incorporated with the module package structure to provide a reliable, cost effective approach to MCM construction for many all-digital, high reliability applications.

The MCM-D substrate category that is of interest in this patent application is constructed by thin film deposition technologies (as indicated by the -D qualification of the MCM technology type), for example with a multilayer aluminium-polyimide metallisation structure (as typical of a silicon MCM substrate), with typically three or four layers of interconnect; a ground plane, a power plane and one or two layers for signal trace routing. A five layer construction is also sometimes employed, the fifth layer being used to place chip connection pads, thus avoiding any constraint on routing in the two signal routing layers below.

The track geometries on the silicon substrate are between 10 and 25 micrometre line widths, with metal thicknesses of 2 to 5 micrometres at track pitches of 40 to 100 micrometres, while dielectric thicknesses are in the 5 to 20 micrometre range. Such geometries allow controlled impedance, 50 ohm lines to be defined if required. Alternative materials include copper as the conductor material and a range of alternative polymers, including BCB and PPQ. This interconnection technology geometry allows very high interconnection density to be achieved, while the low parasitics of the interconnection traces and the well defined trace impedances provide high bandwidth. The power and ground plane structures provide high performance power and ground connections locally at each mounted device.

A very important and unique capability of the MCM-D substrate option lies in the ability to integrate thin film resistor, capacitor and inductor components into the MCM-D substrate structure as required, for example for line termination, decoupling, biassing, matching, filtering and related functions.

The MCM-D technologies reported by other workers have exhibited two particular technical deficiencies, however, both of which relate to the use of polymeric dielectric materials in the construction of the multilayer substrate structure. The first relates to the difficulty of wire bonding to metallisation pads located on the upper metallisation layer due to the relative softness and compliance of the polymer dielectric. Ultrasonic aluminium wire bonding to aluminium bond pads, for example, requires that the ultrasonic energy is coupled into the metal interfaces. The softness and inherent acoustic damping of the polymer dielectric prevents effective energy coupling. Other workers have been forced to locate wire bond pads in apertures in the substrate structure on the rigid substrate itself to avoid this problem, thus severely compromising the routability of the substrate. The second deficiency is related to the natural tendency of polymer dielectric materials to absorb and be affected by moisture. MCM-D substrates that are exposed to moisture, in service or in reliability testing (for example in autoclave, superheated steam testing), can show marked loss of adhesion between the polymer dielectric layers and to the underlying substrate, or changes in dielectric properties, rendering the substrate structure unreliable.

According to the present invention in a multichip module structure incorporating multilayer metallisation-polymer dielectric deposition on a substrate, a silicon nitride layer is deposited below the uppermost metallisation layer.

Preferably silicon nitride layers are deposited below and above the uppermost metallisation layer.

A thin film deposited multichip module (MCM-D) substrate structure in accordance with the invention will now be described with reference to the accompanying drawings, which show sectional views of parts of the substrate structure.

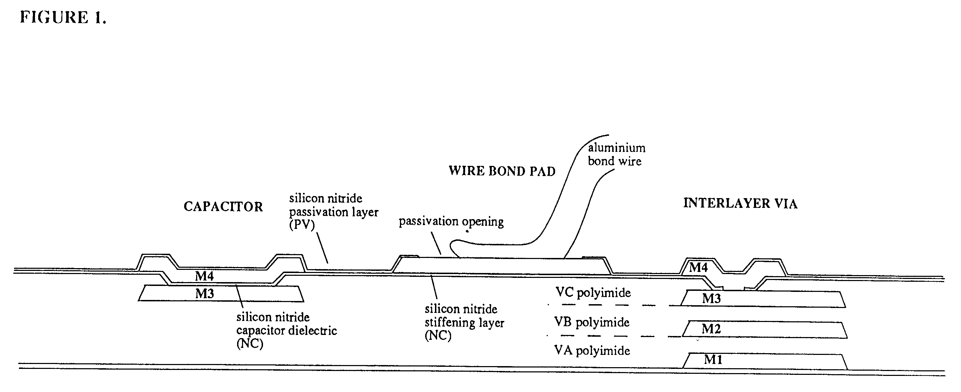

The structure allows high yield and reliable wire bonding to be achieved to pads located on the upper layers of the inherently compliant multilayer polymer dielectric-metallisation substrate structure, provides an inherently reliable and hermetic seal for this multilayer substrate structure and allows high performance integrated thin film capacitors to be defined between the upper and next level metallisation layers. All three of these functions are achieved through the incorporation of just two additional layers of plasma deposited silicon nitride into the upper layers of the multilayer polymer dielectric-metallisation substrate structure. This novel MCM-D substrate structure is illustrated in Figure 1, which shows a four layer aluminium-polyimide structure. A very similar concept may be applied to other MCM-D constructions, comprising two, three or five layer builds and employing different materials combinations.

In the example illustrated, the processing and patterning of the metal 1 (M1),VA polyimide, metal 2 (M2), VB polyimide, and metal 3 (M3) layers are conducted using conventional MCM-D processes to build up the structure on an oxide isolated silicon or sapphire or alumina substrate base. The processes employed may include sputter deposition and wet or dry etching for the aluminium metallisation, with spin or spray coating, curing and wet or dry etching for the polyimide layers. The VC polyimide layer is then applied and cured over the M3 metal layer. Small apertures are then defined in this VC layer where intermetal layer (M3M4) via locations are required (25 micrometres diameter typical), and larger apertures are defined where M3 to M4 capacitor structures are required (150 micrometres to 1mm typical dimensions).

A silicon nitride layer is then deposited, typically by a conformal plasma enhanced chemical vapour deposition (PECVD) process from a silane, ammonia and nitrogen gas mixture at a temperature of over 300°C. This temperature is preferably below that at which the polyimide has been cured. The film thickness is preferably between 0.2 and 1.0 micrometres, although other thicknesses maybe employed as required for particular applications and materials combinations. The deposition conditions are suitably adjusted to control the level of compressive stress in this film, a preferred stress level being 3.10⁹ dynes/cm² for a 0.5 to 1.0 micrometre film. This nitride layer (coded NC) functions as a stiffening layer (for subsequent wire bonding to M4 pads) and as the dielelectric layer for the M3M4 capacitor structures.

Apertures are then defined in this layer (typically by plasma dry etching using established processes) only where M3M4 vias are required. These apertures are preferably of dimensions smaller than that of the via base aperture in the VC layer. The M4 aluminium layer is then deposited and patterned as illustrated, the M4 features extending over the side walls of the M3M4 and M4M3 capacitor areas.

The structure is completed by the deposition and patterning of a second nitride layer (coded PV), as illustrated. Apertures are defined in this second layer, which serves as a protection and passivation layer for the MCM-D structure, where wire bond connections are to be made, or where solderable metallisations and solder bumps are to be defined. This second layer is preferably between 0.2 and 1.0 micrometres in thickness. The use of this second layer provides protection and passivation for the M4 metallisation, and provides a second level of passivation for the underlying polyimide and metal layers. This minimises the probability of coincident pinhole defects being found that expose the polyimide layers to moisture. The use of elevated deposition temperatures for the nitride deposition ensures that the polyimide is entirely moisture free at the point of nitride deposition. The NC via patterning structure ensures that M3M4 via sidewalls are sealed to prevent moisture ingress during processing.

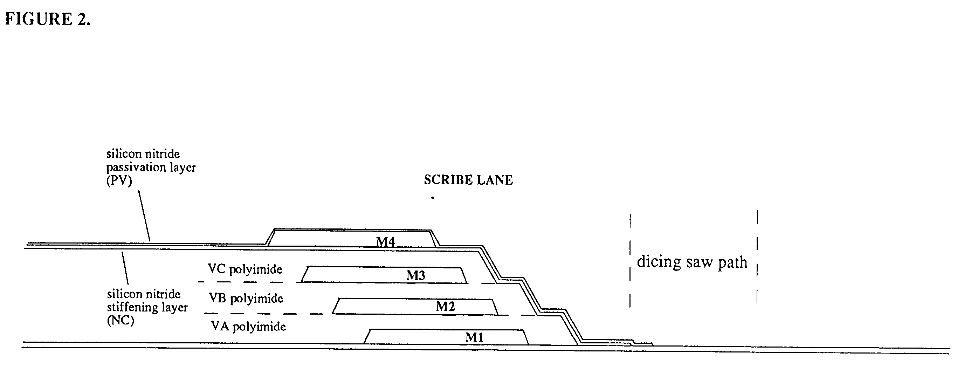

A similar structure is employed in MCM-D scribe channels to prevent moisture being absorbed into what would be cut and exposed edges of the polyimide MCM-D structure were no such structure employed. A scribe lane structure is illustrated in Figure 2. The path of the dicing saw is through a region where only thin oxide and nitride layers are present, the MCM-D structure to the side of the scribe lane being protected by the double layer of nitride passivation (NC plus PV). The metal and polyimide layers in the scribe lane region are arranged in a terrace structure, as illustrated, to ensure that a smooth edge profile is obtained that allows effective and continuous nitride coating to be achieved. The effectiveness of such passivation and scribe lane structures has been confirmed by conducting autoclave test at 120°C for up to 160 hours without any loss of interlayer adhesion or degradation in four layer aluminium-polyimide MCM-D structures. Test samples without the nitride passivation structures showed adhesion loss and corrosion by the end of these tests.

The M3M4 nitride capacitor structure can provide a capacitance of about 100 pF per square mm for a 0.7 micrometre film thickness, a useful value for rf and microwave applications. Such a film thickness also provides a sufficient stiffening effect for high yield wire bonding and a reliable passivation seal for the polyimide. The use of full thickness M3 and M4 electrode layers (resistance of 5 to 10 milliohms per square typical) for such a capacitor ensures low equivalent series resistance and high quality factor for good high frequency performance. Barrier metallisation layers (for example titanium-tungsten) may be required at the lower range of nitride thickness quoted to prevent aluminium hillocking induced defects in the nitride on substrate heat treatments. It should be noted that very thin nitride capacitor structures (below 0.2 micrometres) are normally required to be located on the silicon or alumina/sapphire substrate itself, with refractory metal electrode structures (to avoid hillocking defects). Such electrodes are inevitably of higher resistance than in the present structure. Thus, while higher capacitance per unit area may be achieved (for example, up to 2nF per square mm), the equivalent series resistance will be higher and the applicable frequency range constrained.

The effectiveness of the nitride stiffening layer in ensuring high wire bond strength and yield has also been verified. This approach has allowed fully bonded modules to be produced with over 2,500 wire bonds. Bond strengths and bond strength distributions for the aluminium-polyimide technology are very comparable to those obtained on an aluminium IC metallisation.

## Claims

1. A multichip module structure incorporating multilayer metallisation polymer dielectric deposition on a substrate, wherein a silicon nitride layer is deposited below the uppermost metallisation layer.

2. A multichip module structure in accordance with Claim 1 wherein a further silicon nitride layer is deposited over the uppermost metallisation layer.

3. A multichip module structure in accordance with Claim 1 wherein the silicon nitride layer is between 0.2 and 1.0 micrometres thick.

4. A multichip module structure in accordance with Claim 1 or Claim 3 wherein the silicon nitride layer is utilised as the dielectric of a capacitor, the capacitor being formed between the uppermost metallisation and the next level metallisation layers.

5. A multichip structure in accordance with Claim 4 in which said uppermost metallisation and said next level metallisation layers are of aluminium with refractory barrier metallisation on said layers at least adjacent the intervening silicon nitride layer.

6. A multichip structure in accordance with Claim 5 wherein said refractory barrier metallisation is of titanium-tungsten.

7. A multichip structure in accordance with Claim 1 wherein a scribe lane structure is provided, in which the polymer dielectric and metallisation layers are arranged in a stepped, terrace formation adjacent said scribe lane to enable uniform defect free coverage by said silicon nitride layer.

8. A multichip module structure substantially as hereinbefore described with reference to the accompanying drawings.
